(19) **Europäisches Patentamt European Patent Office Office européen des brevets**

(11) **EP 1 435 623 B1**

(12) **EUROPEAN PATENT SPECIFICATION**

(45) Date of publication and mention of the grant of the patent:
**04.06.2008 Bulletin 2008/23**

(51) Int Cl.:
***G11C 16/10*** *(2006.01)*

(21) Application number: **02425801.4**

(22) Date of filing: **30.12.2002**

(54) **Stabilisation method of the drain voltage in non-volatile multilevel memory cells and relating memory device**

Verfahren zur Stabilisierung der Drain-Spannung in einem nichtflüchtigen Speicher mit mehreren Zuständen und zugehörige Speichervorrichtung

Procédé de stabilisation du potentiel de drain d'une mémoire non-volatile à plusieurs niveaux et dispositif mémoire correspondante

(84) Designated Contracting States:
**DE FR GB IT**

(43) Date of publication of application:
**07.07.2004 Bulletin 2004/28**

(73) Proprietor: **STMicroelectronics S.r.l.**
**20041 Agrate Brianza (Milano) (IT)**

(72) Inventors:
• **Crippa, Luca**
**20040 Busnago (Milano) (IT)**
• **Ragone, Giancarlo**
**10134 Torino (IT)**

(74) Representative: **Botti, Mario**
**Botti & Ferrari S.r.l.,**
**Via Locatelli, 5**
**20124 Milano (IT)**

(56) References cited:
**EP-A- 0 905 710       US-A- 5 546 042**
**US-A1- 2002 101 762       US-B1- 6 285 614**

• **U. TIETZE - CH. SCHENK: "Halbleiter-Schaltungstechnik" 1974 , SPRINGER-VERLAG , BERLIN XP002239657 * page 383 - page 388 * * paragraph [13.2.3]; figure 13.6 ***

**EP 1 435 623 B1**

**Description**

Field of application

The present invention relates to a stabilisation method of the drain voltage in non volatile multilevel memory cells.

The invention relates also to a memory electronic device arranged to implement said method.

More particularly, the invention relates to a multilevel non volatile memory electronic device monolithically integrated on a semiconductor and comprising a programming circuit associated to a matrix of nonvolatile memory cells each one being equipped with at lest a floating gate transistor with corresponding source, drain and gate terminals, each programming circuit incorporating a drain voltage regulator having an output connected to the cell drain terminals in a common circuit node and through a metal line conduction path having a parasitic intrinsic resistance.

Even more generally, the invention relates to a method for stabilising the voltage at both ends of a load among a plurality of loads associated to a supply line and active one at a time, of the type wherein the application of said voltage is provided through a voltage regulator having an output connected to the loads by means of said supply line and a plurality of routing resistances, each one being associated to a corresponding load.

Prior art

As it is well known in this specific technical field, during the programming step of a Flash memory cell, it is important to set the voltage applied to its terminals (Gate Source Drain and Body).

In the multilevel flash memory field, wherein the cell is programmed at different threshold voltage values, the node stability becomes an even more critical problem.

Several voltage regulators designed to reduce an output voltage variations are known from the US Patents No. 5,546,042 issued on August 13, 1996 to Tedrow et al. and No. 6,285,614 issued on September 4, 2001 in the name of Mulatti et al., as well as from the EP Patent Application published under No. 0 905 710 on March 31, 1999 in the name of STMicroelectronics S.r.l..

Moreover, stabilised suppliers are described in the textbook "Halbleiter-Schaltungstechnik" to Tietze et al., pages 383-388 (XP002239657). In particular, as described in paragraph 13. Stabilisierte Netzgeräte, a voltage value across a user load is kept constant by inserting an output resistor for measuring an output voltage close to the user.

The simple case of programming a multilevel cell with two bits per cell will be considered first, i.e. a two-level cell with four possible combinations of storable logic values.

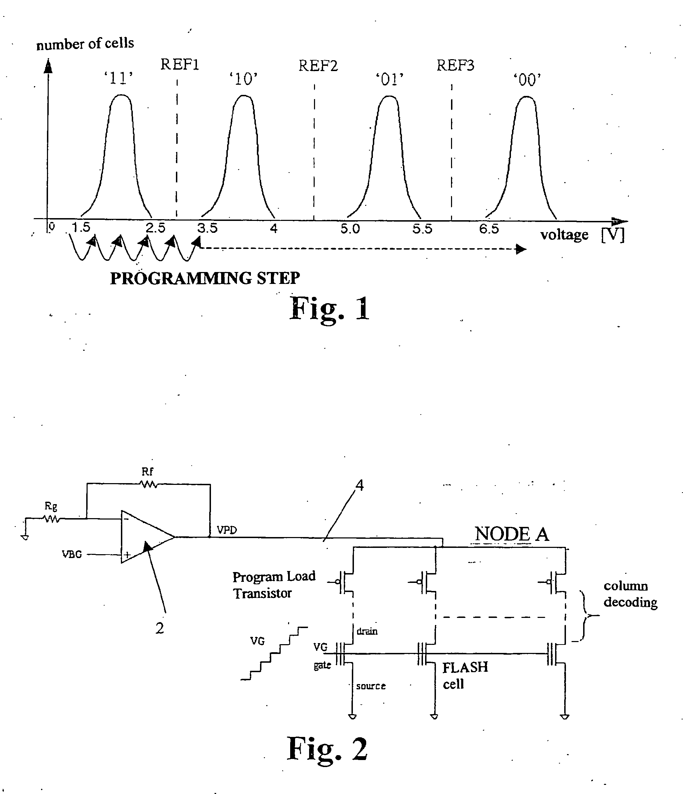

The attached figure 1 shows the distributions of the four different programming states of this cell, that is the distributions of its possible threshold voltage values.

The programming step of a Flash cell is always preceded by an erasing step; consequently, in the beginning the cell is brought to the state "11", the state with the lowest threshold.

The programming algorithm can be split into n almost identical steps. In the first part of each of these steps the Flash memory cell is biased keeping the Drain node at a fixed voltage value (typically +4V), the Source node to ground and the Body at a fixed negative value (typically -1,2V).

The Gate node is initially set at a voltage of 1,5V, to be then increased in following steps (for example) by 300mV at each further step. This leads to an increase by steps in the cell threshold voltage, as shown in figure 1.

In the second part of each single programming step the state of the cell is tested through a reading operation (verify); if the cell does not reach the desired distribution, the operation is repeated by increasing the gate voltage. If, on the contrary, the cell threshold voltage reaches the desired distribution, the programming ends.

In fact the programming step does not involve only one cell, but it is applied in parallel to a certain number of cells. When one or more cells reach the desired threshold value (i.e. it reaches the desired threshold distribution), they are "excluded" from the following programming step which continues only for the remaining cells which must still reach the predetermined state.

In memory devices of more recent production the programming step involves in parallel about seventy cells, which are a variable current load for the drain voltage regulator during the different programming steps.

In fact, the changes of the threshold voltage and of the applied gate voltage cause a different current absorption by the memory cells; moreover, when the cells have reached the desired state, they are disconnected through a program load transistor, for example as shown in the electric scheme of figure 2.

It can thus be understood that the cell drain voltage regulator, in the different programming steps, must provide a constant voltage value, but in different current load conditions.

The drain voltage VPD (+4V) is derived from the Band Gap reference voltage (VGB) according to the following relation:

$$V_{PD} = V_{BG} \cdot \left(1 + \frac{R_f}{R_g}\right)$$

Which expresses the gain of a fedback voltage amplifier, in a noninverting configuration.

The drain regulator, for layout requirements, can be at a certain distance from the program load transistors (PL). The interconnection metal line bringing the adjusted voltage VPD to these transistors, inserts a parasitic resistance, quantifiable in some tens of ohms. Considering that each memory cell can absorb a drain current of about 60µA, with seventy cells being programmed the total current can reach 4mA.

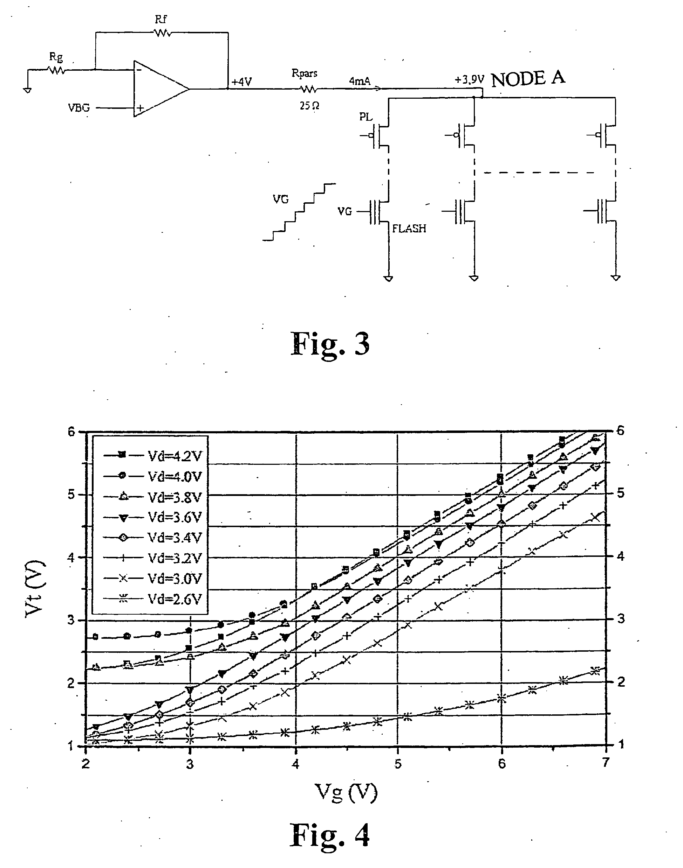

Supposing to have a parasitic resistance Rpars whose metal is equal to 25Ω, as shown in figure 3, the voltage drop on the metals can reach up to 100 mV.

Since the cells which have reached the convenient distribution are disconnected from the adjusted voltage VPD, the cells whereon the programming step continues can have a drain voltage being changed by exactly + 100mV, in the borderline case.

Some typical curves showing the threshold voltage change in the programming step according to different drain voltage values are schematically represented in figure 4. The diagram of figure 4 indicates in the abscissa the gate voltage and in the ordinate the threshold voltage.

If the drain voltage is constant during all the programming steps, the cell threshold voltage change follows one of these characteristics. If, on the contrary, the drain voltage changes in programming, the threshold voltage change translates on another characteristic.

This results in a higher threshold jump and in a widening of the distributions of figure 1 with a corresponding decrease in the reading noise margin or, in the worst case, in real failures due to an excessive distribution widening.

The technical problem underlying the present invention is to provide a method for stabilising the drain voltage and a corresponding non volatile memory device having respective functional and structural characteristics as to improve the Flash cell drain voltage stability, avoiding however the use of voltage regulators positioned near the cell drains. Based on the above, the drain voltage is influenced by the change in the current absorption during the different programming steps.

Summary of the invention

The technical problem is solved by a method as defined in claim 1.

The features and advantages of the method according to the invention will be apparent from the following description of an embodiment thereof given by way of non-limiting example with reference to the attached drawings.

Brief description of the drawings

Figure 1 schematically shows a comparative diagram between the threshold voltage distribution in a conventional two-level memory cell with two bits per cell;

Figure 2 is a schematic view of a known programming circuit of the program load type;

Figure 3 shows in a voltage/voltage diagram some curves which are typical of a multilevel memory cell;

Figure 4 shows the evolutions of the curves which are typical of the threshold voltages according to the drain voltages;

Figure 5 is a schematic view in principle of a device useful in understanding the invention;

Figure 6 is a schematic view of a device useful in understanding the invention;

Figures 7A and 7B are respective schematic views of the circuit layout of a device;

Figures 8A, 8B and 8C respectively show on diagrams according to time the evolution of voltage signals and current in the devices;

Figures 9A, 9B, 9C and 9D are respective schematic views of an example of application of the method according to the invention to a plurality of loads distributed along a resistive line.

Detailed description

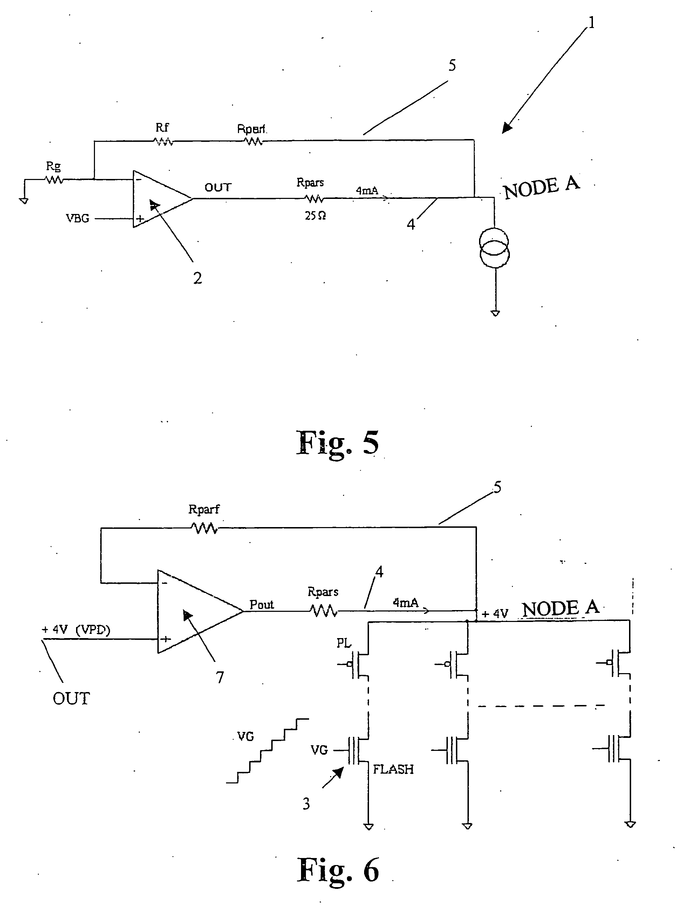

With reference to the figures, and particularly to the examples of figures 5 and 6, a circuit portion 1 of a memory electronic device according is globally and schematically indicated with 1.

The circuit portion 1 is structured to locally regulate voltage values on the drain terminals of multilevel non volatile memory cells 3 during the programming step thereof. More particularly, the circuit portion 1 refers to a drain regulator 2 connected to a load circuit node A by means of a metal line 4.

The memory matrix columns, i.e. the drain terminals of memory cells 3, belong to the circuit node A, with starting interposition of a program load transistor PL.

Memory device means any monolithic electronic system incorporating an matrix of memory cells, organised in rows and columns, as well as circuit portions associated to the cell matrix and responsible for the addressing, decoding, reading, writing and erasing of the memory cell content.

Such a device can be for example a semiconductor-integrated memory chip and of the non volatile EEPROM Flash type split in sectors and electrically erasable.

Each multilevel memory cell comprises a floating gate transistor with source S, drain D and control gate G terminals.

Among the circuit portions associated to the cell matrix programming circuits are provided, each circuit being supplied by a specific supply voltage generated inside the integrated memory circuit and regulated by means of said drain voltage regulator 2.

It has been provided to feedback-connect said node A to an input of the regulator 2. The parasitic resistance $R_{pars}$ on the metal line is therefore substantially incorporated in the feedback loop.

A first example provides that the drain voltage regulator 2, output-connected to the node A by means of the metal line 4, has an input feedback-connected to the same node A.

A first resistance Rf, of gain, and a second resistance $R_{parf}$ representing the parasitic resistance of the feedback metal line 5 are indicated on the feedback path 5

The series of resistances RF and $R_{parf}$ is thus a resistive value which can be assigned to this feedback connection.

The regulator 2 input interested in the feedback is the inverting input (-); ); the other input is kept at a stable voltage reference, for example a bandgap voltage Vbg.

This configuration makes the node A voltage independent from the parasitic resistance $R_{pars}$ value and thus from the variable current load.

Therefore, advantageously, the feedback node is no more drawn as in prior art figure 2 at the regulator 2 output, but near the program load transistors PL. The interconnection parasitic resistance $R_{pars}$ is thus incorporated inside the feedback loop.

Moreover, since at the amplifier inverting input the node OUT is no more fedback, but node A is fedback, this expedient allows a voltage value regulated to 4V to be kept on said node A.

In fact it does not matter that the voltage is regulated to 4V at the voltage regulator 2 output, but on the load node A. The node OUT is thus regulated by the feedback to obtain 4V on the node A.

The node OUT will move on the basis of the load current according to the following relation:

$$V_{OUT} = Iload * Rpar + V_{NODA}$$

While the voltage on node A satisfies the following formula:

$$VnodoA = V_{BG} \cdot \left( 1 + \frac{R_f + R_{parf}}{R_g} \right)$$

Where Rparf is the parasitic resistance of the feedback metal line 5 equal to some hundreds of ohms, and it can be also ignored if Rf is high enough.

This parasitic resistance Rparf, once estimated, does not cause voltage changes in node A since the load current does not flow in this resistance.

With particular reference to the example of figure 6, an alternative is now described.

A unitary gain buffer 7, for example of the Voltage Follower type, is provided to be inserted immediately downstream of the drain voltage regulator 2.

This second solution, though preserving the advantages of the previous solution, has the further advantage of totally eliminating also the parasitic resistance $R_{parf}$ effect of the feedback metal line 5.

The feedback node A is drawn once again downstream of the resistance $R_{pars}$ and not at the regulator 2 output.

This configuration keeps the voltage upstream of the Program Load transistors exactly equal to the voltage VPD at inputting buffer 7, and the gain (unitary) of the latter is not influenced by the resistance $R_{parf}$.

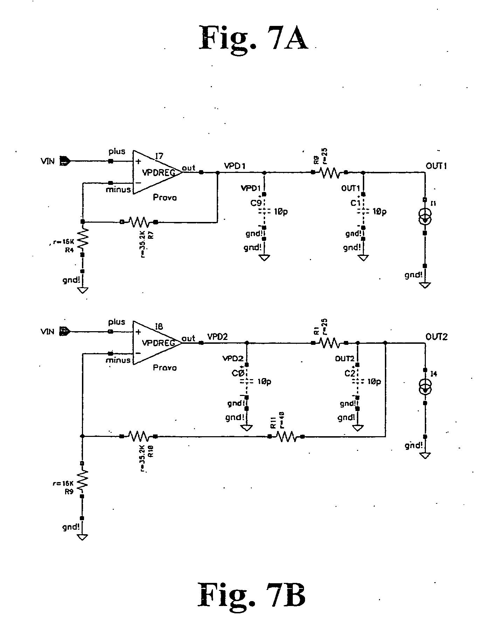

Figures 7A and 7B show the detailed electric schemes of a known solution, for example the solution schematised in figure 2, and of the solution schematised in figure 5.

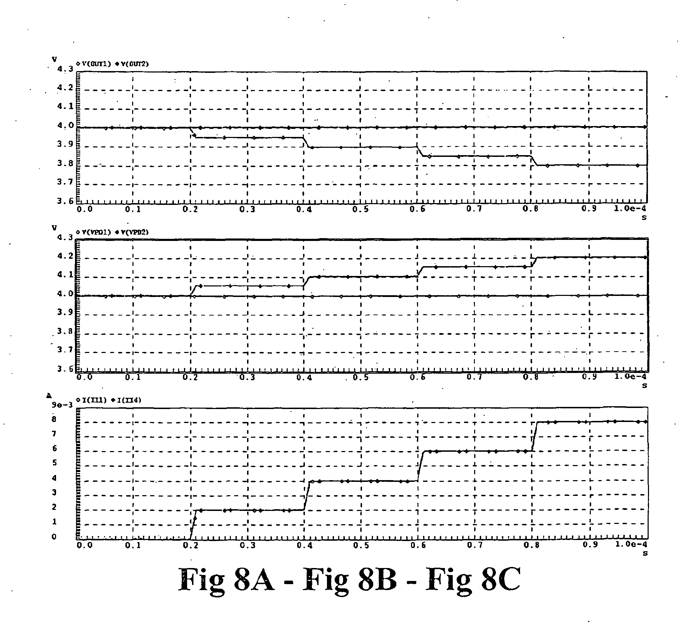

With reference to figures 7A and 7B, in figures 8A, 8B and 8C the evolutions of voltage values according to the current load can be compared to each other, with the known solution (short dashes line) and the solution of the invention (continuous line).

The method and device are particularly effective in all those situations requiring a plurality of loads belonging to a same resistive line, not necessarily memory cells connected to a same metal line, to be supplied with constant regulated voltages.

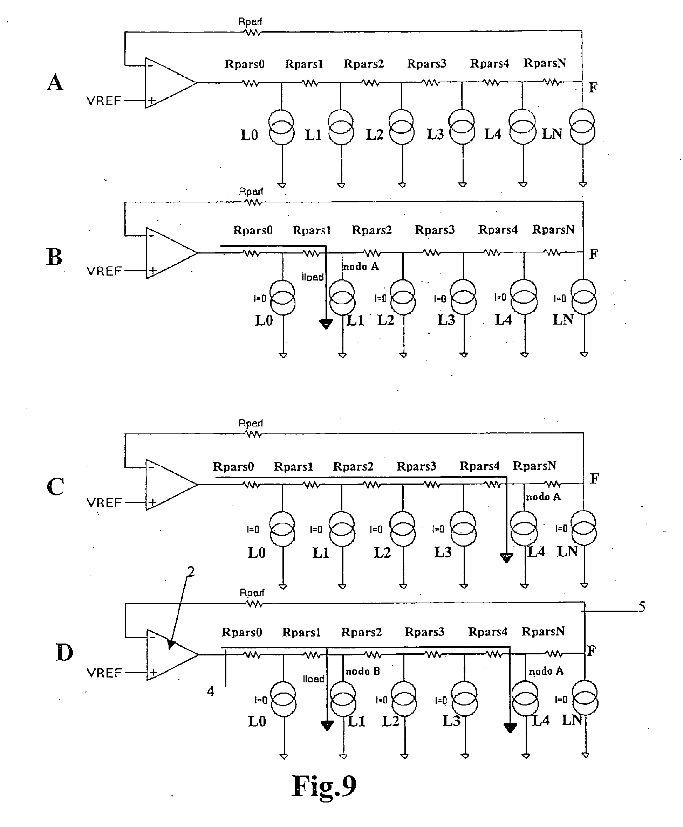

Let's suppose for example to be in a situation as the one shown in figure 9A representing an embodiment of the present invention and requiring some load sources L0, L1, ..., LN spaced from each other; and thus with different associated routing resistances Rpars0, Rpars1, ..., RparsN, to be supplied with different voltages VREF.

In this case line 4 is a supply line which, starting from the regulation 2 output, distributes the voltage to the loads by means of said routing resistances Rpars0, Rpars1, ..., RparsN associated to each load.

The node indicated with F near the farthest load from the regulator is the node to be used for the feedback connection 5 of the regulator 2.

Let's suppose then that only one load, for example L1, absorbs current, while the others are off or have a void current absorbed. On node A connected to L1 the desired voltage VREF is reached; in fact on the right of node A there is no current absorption since the current generators on the right are off. Moreover, the inverting input of the regulator 2 has a high impedance since it is generally formed by means of the gate terminal of a MOS transistor.

If the load L1 is now deactivated, and in the meantime another load is enabled, for example L4, the voltage VREF reaches the node to which the load L4 is connected, indicated in figure 9C still with node A.

In substance, the voltage supplied to each single load is stable against changes in the load being from time to time operative.

In conclusion, the method and the programming circuit according to the invention solve the technical problem and allow the voltages at the drain memory cell terminals to be stabilised during the multilevel Flash memory programming steps.

Moreover, the previously shown solution, by acting in order to keep the value of these voltages stable in programming, allows gate pulses applied during the programming algorithm to effectively realise a threshold voltage jump which is constant for each pulse with any kind of programming pattern.

## Claims

1. A method for stabilising the voltage at both ends of a load (Li) among a plurality of loads (L0, L1, ..., Ln) associated to a supply line (4) and active one at a time, of the type in which the application of said voltage is provided by means of a voltage regulator (2) having an output (OUT) connected to the loads through said supply line (4) and a plurality of series-connected routing resistances ($R_{pars0}$, $R_{pars1}$, ..., $R_{parsN,}$), each of said resistances having one end connected to a corresponding one of said loads (L0, L1, ..., Ln), **characterised in that** it provides a feedback path (5) between one end (F) of the farthest load (Ln) from the regulator (2) and an input of the regulator (2) itself.

2. A method according to claim 1, **characterised in that** said feedback path (5) comprises only a parasitic intrinsic resistance ($R_{parf}$) having a negligible value.

## Patentansprüche

1. Verfahren zur Stabilisierung der Spannung an beiden Enden einer Last (Li) unter einer Mehrzahl von Lasten (L0, L1, ..., Ln), die mit einer Versorgungsleitung (4) assoziiert sind, und wobei eine jeweils aktiv ist, des Typs in welchem das Anlegen der Spannung mittels eines Spannungsregulators (2) vorgesehen ist, der einen Ausgang (OUT) aufweist, der mit den Lasten über die Versorgungsleitung (4) und eine Mehrzahl von Reihe-verbundenen Routing-Widerständen ($R_{pars0}$, $R_{pars1}$, ..., $R_{parsN}$) verbunden ist, wobei jeder der Widerstände ein Ende aufweist, das mit einer entsprechenden der Lasten (L0, L1, ..., Ln) verbunden ist, **dadurch gekennzeichnet, dass** es einen Rückkopplungspfad (5) zwischen einem Ende (F) der von dem Regulator (2) am weitesten entfernten Last (Ln) und einem Eingang des Regulators (2) selbst vorsieht.

2. Verfahren nach Anspruch 1, **dadurch gekennzeichnet, dass** der Ruckkopplungspfad (5) nur einen parasitären intrinsischen Widerstand ($R_{parf}$) mit einem vernachlässigbaren Wert aufweist.

## Revendications

1. Procédé de stabilisation de la tension aux deux extrémités d'une charge (Li) parmi une pluralité de charges (L0, L1, ..., Ln) associées à une ligne d'alimentation (4) et actives une à la fois, du type dans lequel l'application de ladite tension est fournie par le biais d'un régulateur de tension (2) présentant une sortie (OUT) connectée aux charges par le biais de ladite ligne d'alimentation (4) et d'une pluralité de résistances d'acheminement connectées en série ($R_{pars0}$, $R_{pars1}$, ..., $R_{parsN}$), chacune desdites résistances présentant une extrémité connectée à une charge correspondante parmi lesdites charges (L0, L1, ..., Ln), **caractérisé en ce qu'**il fournit une voie de rétroaction (5) entre une extrémité (F) de la charge la plus éloignée (Ln) par rapport au régulateur (2) et une entrée du régulateur (2) lui-même.

2. Procédé selon la revendication 1, **caractérisé en ce que** ladite voie de rétroaction (5) ne comprend qu'une résistance intrinsèque parasite ($R_{parf}$) présentant une valeur négligeable.

**Fig. 1**

**Fig. 2**

**Fig. 3**

**Fig. 4**

**Fig. 5**

**Fig. 6**

# Fig. 7A

# Fig. 7B

Fig 8A - Fig 8B - Fig 8C

Fig.9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5546042 A, Tedrow
- US 6285614 B

- EP 0905710 A

### Non-patent literature cited in the description

- **TIETZE et al.** *Halbleiter-Schaltungstechnik,* 383-388